# FASCICULE DE BREVET EUROPEEN

(11) **EP 3 011 614 B1**
(45) Date de publication et mention de la délivrance du brevet: **14.04.2021**
(21) Numéro de dépôt: 14812961.2
(22) Date de dépôt: 20.06.2014
(51) Int. Cl.: H01M 4/04, H01M 4/02, H01M 4/13, H01M 4/133, H01M 4/134, H01M 4/139, H01M 4/40, H01M 4/583, H01M 4/62, H01M 4/66, H01M 4/70, H01M 4/1395, H01M 4/36, H01M 4/38, H01M 4/485, H01M 4/587, H01M 10/052

(54) **ANODE POUR BATTERIES À HAUTE ÉNERGIE**
ANODE FÜR HOCHENERGIEBATTERIEN
ANODE FOR HIGH-ENERGY BATTERIES

(30) Priorité: 21.06.2013 CA 2820468
(43) Date de publication de la demande: 27.04.2016
(73) Titulaire: Hydro-Québec, Montréal QC H2Z 1A4 (CA)
(72) Inventeur: ZAGHIB, Karim, Longueuil, Québec J4N 1T8 (CA); LEBLANC, Dominic, Gentilly, Québec G9H 4J4 (CA); GUERFI, Abdelbast, Brossard, Québec J4X 1W2 (CA); TROTTIER, Julie, Mirabel, Québec J7J 2J4 (CA); CHAREST, Patrick, Sainte-Julie, Québec J3E 1P2 (CA)
(74) Mandataire: Lang, Johannes
(86) Numéro de dépôt international: PCT/CA2014/050585
(87) Numéro de publication internationale: WO 2014/201569

(56) Documents cités:
- JP-A- 2013 077 398
- US-A- 5 387 479
- US-A- 6 025 094
- US-A1- 2003 036 000
- US-A1- 2005 136 330
- US-A1- 2007 059 600
- US-A1- 2007 059 600
- US-A1- 2008 102 370
- US-A1- 2008 102 370
- US-A1- 2008 193 831
- US-A1- 2012 231 339
- US-A1- 2012 264 020
- US-A1- 2012 270 114
- US-A1- 2013 149 605
- US-B2- 6 589 696
- US-B2- 7 327 556
- US-B2- 7 629 083
- LU ET AL.: 'Preparation, Characterization and Electrochemical Performance of Silicon Coated Natural Graphite as Anode for Lithium Ion Batteries' INT. J. ELECTROCHEM. SCI. vol. 7, 01 Juillet 2012, pages 6180 - 6190, XP055302715

## Description

### DOMAINE TECHNIQUE

La présente invention concerne généralement des anodes pour batteries à haute énergie. Spécifiquement, la présente invention concerne une anode comprenant un matériau d'anode, un matériau protecteur et un collecteur de courant, pour batterie au lithium.

### ÉTAT DE LA TECHNIQUE

On connaît les batteries qui fonctionnent par circulation réversible d'ions lithium à travers un électrolyte contenant un sel de lithium. Dans ce type de batterie, la cathode comprend un collecteur de courant portant une matière active composite généralement constituée par une matière active permettant l'insertion réversible d'ions lithium à potentiel élevé, un liant, un agent de conduction électronique et éventuellement un agent de conduction ionique. L'électrolyte est une solution d'un sel de lithium dans un solvant liquide, un solvant polymère ou un polymère gélifié. Et l'anode est constituée par un film de lithium ou d'alliage de lithium, ou par un collecteur de courant qui porte une matière active constituée par un composé permettant l'insertion réversible d'ions lithium à potentiel plus faible que celui de la cathode, par exemple du carbone, du graphite, un oxyde, ou du silicium.

L'insertion réversible d'ions lithium dans le matériau d'électrode provoque une variation volumique dudit matériau, à savoir une augmentation de volume lors de l'insertion, et une diminution de volume lors de la désinsertion. Cette variation de volume provoque des effets néfastes pour la batterie, tels que la fissuration de la couche de passivation qui se forme à la surface de l'électrode au cours du premier cyclage, ladite fissuration entraînant une perte de capacité et/ou de conductivité électronique. Ces phénomènes peuvent être constatés par des études utilisant la technique d'analyse microscopie électronique à balayage (MEB) *in situ.*

L'ampleur de la variation de volume dépend de la nature du matériau. Par exemple, dans deux batteries qui ne diffèrent que par la nature du matériau constituant l'anode, l'on constate que la variation de volume d'une anode de carbone ou de graphite est relativement faible, généralement reste inférieure à 10%, ce qui limite les problèmes de fissuration et de perte de capacité qui en découlent. En revanche, la variation de volume d'une anode constituée par du silicium ou un alliage de silicium est nettement plus élevée. Elle peut être de 300% pour un alliage de silicium et de lithium (Si-Li), ce qui est nuisible au bon fonctionnement de la batterie. Cependant, la capacité maximale permise par une anode de carbone est de l'ordre de 370 mAh/g, alors que la capacité maximale permise par une anode constituée d'un alliage Si-Li est supérieure d'un facteur 10. Ainsi, une anode constituée d'un alliage Si-Li permet d'obtenir une bonne capacité maximale, mais présente une grande variation volumique du matériau au cours du cyclage.

Le document JP 2013-077398 divulgue une anode comprenant un collecteur de courant sur lequel sont déposées successivement deux sous-couches de matériau d'anode contenant chacune un matériau d'anode, les deux sous-couches constituant ensemble la couche d'anode. Le document US 2007-059600 divulgue une anode comprenant un matériau d'anode, deux couches de liant et un collecteur de courant. Le premier liant a une élasticité supérieure à celle du second liant, ce dernier étant adapté pour lier le matériau au collecteur de courant. Le document 5,387,479 divulgue une batterie comprenant une couche protectrice entre le matériau d'anode et l'électrolyte, la couche permettant de réduire la passivation de l'électrode. Le document US 6,025,094 divulgue une anode comprenant une couche protectrice comprenant des ions de métaux alcalins.

Il est désirable d'avoir une anode permettant d'obtenir une bonne capacité maximale tout en présentant une faible variation volumique du matériau au cours du cyclage.

### RÉSUMÉ DE L'INVENTION

Les inventeurs dans la présente invention ont développé une anode permettant d'obtenir une batterie ayant une capacité de l'ordre de celle obtenue avec des alliages Si-Li, et pour laquelle la variation volumique au cours du cyclage de la batterie reste faible.

L'anode selon l'invention comprend un matériau d'anode, un matériau protecteur et un collecteur de courant. Le matériau d'anode est constitué par un mélange comprenant une matière active qui est un alliage de silicium et de lithium ou un alliage d'oxyde de silicium et de lithium, un agent de conduction électronique, et un liant. Le collecteur de courant est une plate métallique.

Dans l'anode selon l'invention, le matériau d'anode est déposé sur la plaque métallique sous forme de film, et le matériau protecteur est déposé sur le film de matériau d'anode sous forme de film (film protecteur). Selon l'invention, l'anode comporte plus d'un film protecteur.

La présente invention se rapporte également à un procédé de préparation de l'anode, une batterie contenant ladite anode, utilisation ladite anode dans la fabrication d'une batterie, et un procédé de fabrication d'une batterie.

D'autres avantages pourront encore apparaître à l'Homme du métier à la lecture des exemples ci-dessous, illustrés par les figures annexées, données à titre illustratif.

### BRÈVE DESCRIPTION DES FIGURES

La Figure 1 illustre une anode.
La Figure 2 illustre une anode selon l'invention.
La Figure 3 représente une courbe de décharge/charge d'une batterie incorporant une variante de l'anode avec le film protecteur.
La Figure 4 représente une courbe de décharge/charge d'une batterie incorporant une anode sans le film protecteur.
La Figure 5 représente une courbe de décharge/charge d'une batterie incorporant une variante de l'anode avec le film protecteur.
La Figure 6 représente une courbe de décharge/charge d'une batterie incorporant une variante de l'anode avec le film protecteur.

### DESCRIPTION DE MODES DE RÉALISATIONS DE L'INVENTION

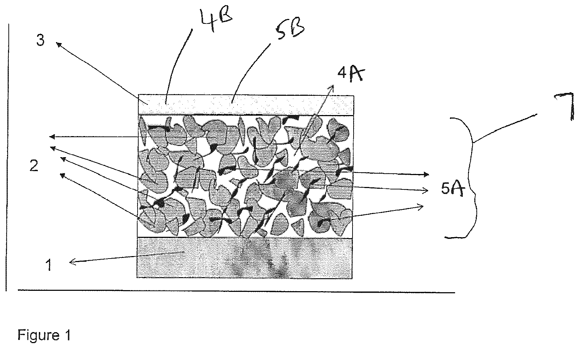

Une anode est illustrée sur la Figure 1. Elle comprend un collecteur de courant **1,** un film de matériau d'anode **7** et un film protecteur **3.** Le film de matériau d'anode **7** est constitué par des particules de matière active **2** et des particules d'au moins un agent de conduction électronique **5A,** dans un liant **4A**.

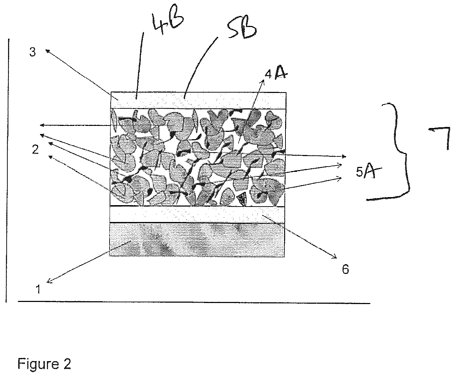

Dans un mode de réalisation particulier de l'invention illustré à la Figure 2, l'anode comporte deux films protecteurs **3, 6.** Les films protecteurs **3, 6** peuvent être identiques ou différents.

Le collecteur de courant **1** peut être une feuille de cuivre ou d'aluminium. Lorsque le collecteur de courant est une feuille d'aluminium, il se forme un alliage d'aluminium et de lithium (Al-Li) à l'interface entre le film de matériau d'anode et la feuille d'aluminium, lorsque l'anode est soumise à un cyclage. Ce phénomène a pour avantage de limiter l'extension volumique du matériau d'anode lors de l'insertion ou la désinsertion des ions lithium.

Lorsque le collecteur de courant **1** est une feuille de cuivre, selon un mode de réalisation particulière de l'invention illustré à la Figure 2, l'anode comporte deux films protecteurs **3, 6,** le film de matériau d'anode 7 étant situé entre les deux films protecteurs. Ceci, étant donné que le cuivre ne forme pas d'alliage avec le lithium ou le silicium.

Le matériau d'anode **7** est constitué par un mélange comprenant des particules de matière active **2** qui est un alliage de silicium et de lithium ou un alliage d'oxyde de silicium et de lithium, des particules d'au moins un agent de conduction électronique **5A,** et un liant **4A.**

L'agent de conduction électronique **5A** est un carbone conducteur électronique choisi parmi les noirs de carbone, les noirs d'acétylène, les fibres de carbone, les nanotubes de carbones et les graphènes. Les fibres de carbone peuvent être les fibres de carbone dites « vapor grown carbon fiber » (VGCF), commercialisées par la compagnie Showa-Denko.

Selon un mode de réalisation de l'invention, le matériau d'anode **7** contient en outre un graphite naturel ou synthétique. Le rapport en poids matière active/graphite peut être autour de 1/1.

Selon un mode de réalisation de l'invention, l'agent de conduction électronique **5A** est constitué de fibres VGCF et d'un autre carbone conducteur électronique. Le rapport en poids fibres VGCF/autre carbone conducteur électronique peut être autour de 1/1.

Le liant **4A** est un polymère. Par exemple, il peut être un polyfluorure de vinylidène (PVDF), un copolymère de fluorure de vinylidène et d'hexafluoropropène (PVFD-HFP), un polyimide, une carboxyméthyle cellulose (CMC), un alginate sous forme d'acide ou sous forme d'un sel, ou un mélange de plusieurs d'entre eux. Le cation de l'alginate peut par exemple être Na, Li, K, Ca, Mg, Al ou NH₄.

Le film protecteur **3, 6** est constitué par des particules d'au moins un agent de conduction électronique **5B** et un liant **4B**. L'agent de conduction électronique **5B** et le liant **4B** sont tels que décrits ci-dessus pour le matériau d'anode **7.**

L'agent de conduction électronique dans le matériau d'anode **5A** et l'agent de conduction électronique dans le film protecteur **5B** peuvent être identiques ou différents. Ces agents de conduction électronique sont indépendamment choisis parmi : les noirs de carbone, les noirs d'acétylène, les fibres de carbone, les nanotubes de carbones et les graphènes. Les fibres de carbone peuvent être les fibres de carbone dites « vapor grown carbon fiber » (VGCF), commercialisées par la compagnie Showa-Denko.

Selon un mode de réalisation de l'invention, l'agent de conduction électronique du matériau d'anode **5A** et l'agent de conduction électronique du film protecteur **5B** sont identiques.

Selon un mode de réalisation de l'invention, le liant du matériau d'anode **4A** et le liant du film protecteur **4B** sont identiques.

Selon un mode de réalisation de l'invention, les proportions en poids des constituants du matériau d'anode 7 sont :
- matière active : 80-95%
- conducteur électronique : 1-10%
- liant : 2-20%.

Selon un mode de réalisation de l'invention, les proportions en poids des constituants du film protecteur **3, 6** sont :
- conducteur électronique : 1-20%
- liant : 80-99%.

Selon un mode de réalisation de l'invention, le film de matériau d'anode **7** a une épaisseur autour de 5 à 150 µm, de préférence de 30 à 50 µm; la feuille métallique constituant le collecteur de courant **1** a une épaisseur autour de 1 à 25 µm, de préférence 10 à 15 µm; et chacun des films protecteurs **3, 6** a une épaisseur autour de 1 à 5 µm.

### Procédé d'élaboration de l'anode

Une anode selon l'invention peut être élaborée par un procédé comprenant les étapes suivantes :
a) préparation d'une composition destinée à former le film de matériau d'anode **7,** en mélangeant une matière active ou un précurseur de matière active d'anode, un liant et un agent de conduction électronique, dans un solvant;
b) préparation d'une composition destinée à former le film protecteur **3, 6,** en mélangeant un agent de conduction électronique avec un liant, dans un solvant;
c) dépôt de la composition destinée à former le film de matériau d'anode sur un film métallique destiné à former le collecteur de courant, et élimination du solvant; et
d) dépôt de la composition de matériau destiné à former le film protecteur à la surface du film de matériau d'anode, et élimination du solvant.

Selon un mode de réalisation de l'invention, la préparation de la composition destinée à former le film protecteur **3, 6** (étape b)) peut être effectuée avant la préparation de la composition destinée à former le film de matériau d'anode **7** (étape a)).

Lorsque l'anode comprend un film protecteur **6** entre le collecteur de courant **1** et le film de matériau d'anode **7** (Figure 2), le procédé comprend une étape b') consistant à préparer une composition destinée à former le film protecteur **6,** à déposer ladite composition sur un film métallique destiné à former le collecteur de courant **1** et à éliminer le solvant, le dépôt de l'étape c) étant ensuite effectué sur la surface du film protecteur **6,** avant la mise en œuvre de l'étape d).

Le solvant utilisé pour la préparation de la composition destinée à former le film de matériau d'anode **7** dépend de la nature du liant **4A.** Selon un mode de réalisation de l'invention, on utilise la N-méthylpyrrolidone (NMP) ou la cyclopentanone lorsque le liant est PVDF ou un polyimide. L'eau peut être utilisée comme solvant lorsque le liant est un caoutchouc naturel ou synthétique, une carboxyméthylcellulose ou un alginate.

Le précurseur de matière active d'anode introduit dans la composition destinée à former le film de matériau d'anode **7** est une poudre de silicium, d'oxyde de silicium ou d'un alliage Si-Li. Selon un mode de réalisation de l'invention, la composition destinée à former le film de matériau d'anode peut comprendre autour de 5 à 20 parties en poids d'un solvant, et autour de 80 à 95 parties en poids d'un mélange constitué par : 80-95% en poids de précurseur de matière active, 2-20% en poids de liant, et 1-10% en poids de carbone conducteur électronique.

Pour la préparation de la composition destinée à former le film protecteur **3, 6,** le solvant utilisé dépend de la nature du liant **4B.** Selon un mode de réalisation de l'invention, on utilise comme solvant la N-méthylpyrrolidone (NMP) ou la cyclopentanone lorsque le liant est PVDF ou un polyimide. L'eau peut être utilisée comme solvant lorsque le liant est un caoutchouc naturel ou synthétique, une carboxyméthylcellulose (CMC) ou un alginate. La composition destinée à former le film protecteur **3, 6** peut comprendre autour de 5 à 20 parties en poids d'un solvant, et autour de 80 à 95 parties en poids d'un mélange constitué par : 1-20% en poids de carbone conducteur électronique, et 80-99% en poids de liant.

Le dépôt des différentes compositions, à savoir, la composition destinée à former le film de matériau d'anode **7** et la composition destinée à former le film protecteur **3, 6,** peut s'effectuer par des méthodes connues de l'Homme du métier. Par exemple, le dépôt peut s'effectuer à l'aide d'une racle (« doctor blade ») ou par extrusion.

Une composition destinée à former l'un des films de l'anode est déposée, soit sur le collecteur de courant, soit sur un film déjà déposé, puis elle est soumise à un traitement thermique pour éliminer le solvant. Selon un mode de réalisation de l'invention, le traitement thermique s'effectue sous vide. La température du traitement thermique dépend du la température d'ébullition du liant utilisé. Elle peut par exemple être autour de 120°C lorsque le liant est PVDF ou CMC, ou autour de 150°C lorsque le liant est une polyimine.

L'élaboration d'une anode et telle qu'illustrée à la Figure **1** comprend deux étapes de dépôt et séchage (dépôt d'une composition suivi du séchage de la composition). La première étape est pour le film de matériau d'anode **7** et la deuxième étape est pour le film protecteur **3.**

L'élaboration d'une anode selon l'invention et telle qu'illustrée à la Figure 2 comprend trois étapes de dépôt et séchage (dépôt d'une composition suivi du séchage de la composition). La première étape est pour le film protecteur **6,** la deuxième étape est pour le film de matériau d'anode **7** et la troisième étape est pour le second film protecteur **3.**

Après élimination du solvant dans tous les films superposés, l'ensemble est comprimé pour supprimer la rugosité et augmenter la densité du matériau d'anode. Selon un mode de réalisation de l'invention, une densité autour d'au moins 1,3 g/cm³ est préférée.

### Utilisation de l'anode dans une batterie aux ions lithium

Une anode selon l'invention est utile dans une batterie aux ions lithium dans laquelle la cathode est constituée par un matériau d'électrode porté par un collecteur de courant et l'électrolyte est constitué par une solution d'un sel de lithium dans un solvant, ledit solvant pouvant être un solvant liquide, un solvant polymère ou un solvant gel.

### Cathode :

Le collecteur de courant de la cathode est de préférence un film d'aluminium. Le matériau porté par le collecteur de courant de la cathode contient une matière active d'électrode positive, éventuellement un agent de conduction ionique et éventuellement un liant. Le choix de la matière active d'électrode positive, de l'éventuel liant et de l'éventuel agent de conduction ionique est à la portée de l'Homme du métier.

La matière active d'électrode positive peut être choisie par exemple parmi les oxydes de vanadium VOₓ (2 ≤ x ≤ 2,5), LiV₃O₈, Li_{y}Ni₁₋ₓCOₓO₂, (0 ≤ x, y ≤ 1), les spinelles de manganèse Li_{y}Mn₁₋ₓMₓO₂ (M = Cr, Al, V, Ni, 0 ≤ x < 0,5 ; 0 ≤ y ≤ 2), les polydisulfures organiques, FeS, FeS₂, le sulfate de fer Fe₂(SO₄)₃, les phosphates et phosphosilicates de fer et de lithium de structure olivine, ou leurs produits de substitution du fer par le manganèse.

Le liant de l'électrode positive peut être un polymère choisi par exemple parmi ceux définis ci-dessus comme liant pour l'anode.

L'agent de conduction électronique de la cathode peut être du noir de carbone, du noir d'acétylène, de la fibre de carbone, ou des nanotubes de carbone.

### Électrolyte :

Le sel de lithium de l'électrolyte peut être choisi parmi les halogénures de lithium LiX (X = Cl, Br, I ou I₃), le perfluorosulfonate de lithium (CₙF₂ₙSO₃Li), le (trifluorométhylsulfonyl)imidure de lithium (N(CF₃SO₂)₂)Li, le bis(trifluorométhylsulfonyl)méthylure de lithium (HC(CF₃SO₂)₂)Li, bis(fluorosulfonyl)imide de lithium (LiFSl), le tris(trifluoro-méthylsulfonyl)méthylure de lithium (C(CF₃SO₂)₃)Li, le perchlorate de lithium (LiClO₄), l'hexafluoroarséniate de lithium (LiAsF₆), l'hexafluorophosphate de lithium (LiPF₆), l'hexafluoroantimonate de lithium (LiSbF₆) et le tétrafluoroborate de lithium (LiBF₄), le dicyanotriazolate de lithium (LiDCTA) et le 4,5-dicyano-2-(trifluoromethyl)imidazolate de lithium (LiTDl).

Lorsque l'électrolyte est un électrolyte liquide, le solvant peut être choisi parmi les liquides organiques aprotiques polaires, les liquides ioniques, ou leurs mélanges.

Comme exemple de liquide aprotique polaire, on peut citer les éthers linéaires et les éthers cycliques, les esters, les nitriles, les dérivés nitrés, les amides, les sulfones, les sulfolanes, les alkylsulfamides et les hydrocarbures partiellement hydrogénés. Les solvants particulièrement préférés sont le diéthyléther, le diméthoxyéthane, le glyme, le tétra-hydrofurane, le dioxane, le diméthyltétrahydrofurane, le formiate de méthyle ou d'éthyle, le carbonate de propylène ou d'éthylène, les carbonates d'alkyle (notamment le carbonate de diméthyle, le carbonate de diéthyle et le carbonate de méthylpropyle), les butyrolactones, l'acétonitrile, le benzonitrile, le nitrométhane, le nitrobenzène, la diméthyl-formamide, la diéthylformamide, le carbonate de vinyle, la diméthylsulfone, la tétraméthylène sulfone, la tétraméthylène sulfone et les tétraalkylsulfonamides ayant de 5 à 10 atomes de carbone.

Les liquides ioniques sont des composés ioniques liquides à la température d'utilisation. On peut citer en particulier les composés ioniques ayant un anion et un cation, dans lesquels :
- l'anion peut être choisi parmi Cl, Br, I, BF₄⁻, R_{f}BF₃⁻, PF₆⁻, N(CN)₂⁻, C(CN)₃⁻, [(C₂O₄)₂B]⁻, RSO₃⁻, ROSO₃⁻ , [RPO₂]⁻, [R(R'O)PO₂]⁻, [(RO)₂PO₂]⁻, R_{f}PF₅⁻, (R_{f})₂PF₄⁻, (R_{f})₃PF₃⁻, R_{f}CO₂⁻, R_{f}SO₃⁻, [(R_{f}SO₂)₂N]⁻, [(R_{f}SO₂)₂CH]⁻, [(R_{f}SO₂)₂C(CN)]⁻, [R_{f}SO₂C(CN)₂]⁻, [(RfSO₂)₃C]⁻, dans lesquels R et R', identiques ou différents, représentent chacun un radical alkyle ayant de 1 à 12 atomes de carbone, aryle ou alkylaryle, et R_{f} est F, CF₃OCF₂, HCF₂CF₂, C₆F₅ ou un radical perfluoroalkyle ayant de 1 à 8 atomes de carbone;
- le cation est un cation ammonium, phosphonium, sulfonium, iodonium, pyridinium, imidazolium, pyrazolium, acetamidinium, oxazolium, thiazolium, pyrrolidinium, pipéridinium, imidazolinium ou guanidinium.

On préfère en particulier le bis-(trifluorométhanesulfonyl)imide de 1-éthyl-3-méthylimidazolium (EMI-TFSI), le bis(fluorosulfonyl) imide de 1-éthyl-3-méthylimidazolium (EMI-FSI), le bis(fluorosulfonyl)imide de N-méthyl-N-propylpyrrolidinium (Py13-FSI), et le bis(fluorosulfonyl)imide de N-butyl-N-méthylpyrrolidinium (Py14-FSI).

Lorsque l'électrolyte est un électrolyte polymère, le solvant polymère peut être choisi parmi les polymères solvatants, réticulés ou non, portant ou non des groupes ioniques greffés. Un polymère solvatant est un polymère qui comporte des unités solvatantes contenant au moins un hétéroatome choisi parmi le soufre, l'oxygène, l'azote et le fluor. À titre d'exemple de polymères solvatants, on peut citer les polyéthers de structure linéaire, peigne ou à blocs, formant ou non un réseau, à base de poly(oxyde d'éthylène), ou les copolymères contenant le motif oxyde d'éthylène ou oxyde de propylène ou allylglycidyléther, les polyphosphazènes, les réseaux réticulés à base de polyéthylène glycol réticulé par des isocyanates ou les réseaux obtenus par polycondensation et portant des groupements qui permettent l'incorporation de groupements réticulables. On peut également citer les copolymères à blocs dans lesquels certains blocs portent des fonctions qui ont des propriétés rédox. On préfère en particulier les polyéthers, plus particulièrement les polyéthers ayant au moins trois branches.

Lorsque l'électrolyte est un électrolyte gel, le solvant du sel de lithium comprend simultanément un solvant liquide choisi parmi les solvants liquides cités ci-dessus et un solvant polymère polaire comprenant des unités contenant au moins un hétéroatome choisi parmi le soufre, l'azote, l'oxygène et le fluor. À titre d'exemple d'un tel polymère polaire, on peut citer les polymères qui contiennent principalement des unités dérivées de l'acrylonitrile, du fluorure de vinylidène, de la N-vinylpyrrolidone ou du méthacrylate de méthyle. Ces polymères peuvent porter des groupements ioniques. La proportion de liquide dans le solvant peut varier de 2% (correspondant à un solvant plastifié) à 98% (correspondant à un solvant gélifié).

Un générateur électrochimique dans lequel l'anode est une anode selon l'invention est assemblé de préférence sous atmosphère inerte.

### EXEMPLES

La présente invention est illustrée par les exemples suivants, auxquels elle n'est cependant pas limitée. Les matériaux suivants ont été utilisés :
- feuille d'aluminium ayant une épaisseur de 12 µm;
- feuille de cuivre ayant une épaisseur de 12 µm;
- particules de SiOₓ (x≈0,95) ayant une dimension moyenne de ≈7 µm et enrobées par un film de carbone ayant une épaisseur de ≈1 nm (désignées ci-après par SiOC);
- polyimide;
- caoutchouc synthétique, dispersible dans l'eau, fourni par la société Zeon (désigné ci-après par SR);
- carboxyméthylcellulose dispersible dans l'eau (désigné ci-après par CMC);
- poly fluorure de vinylidène fourni par la société Kureha (désigné ci-après par PVDF Kureha 10%;
- particules de graphite naturel ayant un diamètre moyen de 12 µm, commercialisé par la société Osaka Gas, sous la dénomination OMAC (désignées ci-après par OMAC);
- fibres de carbone fournies par la société Showa Denko sous la dénomination VGCF-H® (désignées ci-après par VGCF-H®);
- noir d'acétylène fourni par la société Denka (désigné ci-après par AB).

### Exemple 1 : Préparation d'anode (liant polyimide)

On a préparé trois anodes selon le mode opératoire ci-dessous.

### Composition destinée à former le film de matériau d'anode

On a préparé une composition destinée à former le film de matériau d'anode. Les constituants du matériau d'anode sont donnés dans le Tableau 1 ci-dessous. La composition destinée à former le matériau d'anode contient la N-méthylpyrrolidone (NMP) en tant que solvant. Dans la composition destinée à former le matériau d'anode, NMP représente environ 81,28 g.

La composition destinée à former le matériau d'anode a été préparée en dissolvant le polyimide dans NMP, puis en ajoutant les deux matières actives (SiOC et OMAC) et le carbone conducteur électronique (VGCF-H®).

**Tableau 1**

| Ex. | Collecteur | MA* (%) | | MA* (%) | VGCF-H® (%) | Liant | (%) |
|---|---|---|---|---|---|---|---|
| a | Cuivre | SiOC | 40,74 | 81,48 | 3,4 | polyimide | 15,12 |
| | | OMAC | 40,74 | | | | |
| b | Cuivre | SiOC 40,74 OMAC | 40,74 | 81,48 | 3,4 | polyimide | 15,12 |
| c | Cuivre | SiOC 48,89 | | 81,47 | 3,39 | polyimide | 15,14 |
| | | OMAC | 32,58 | | | | |

| | | | | | | | |
|---|---|---|---|---|---|---|---|
| * Matière active | | | | | | | |

### Composition destinée à former le film protecteur

On a préparé une composition destinée à former le film protecteur. Les constituants du film protecteur sont donnés dans le Tableau 2 ci-dessous. La composition destinée à former le film protecteur contient de l'eau en tant que solvant. Dans la composition destinée à former le film protecteur, l'eau représente environ 75,42 g.

La composition destinée à former le film protecteur a été préparée en ajoutant SR et CMC dans l'eau, puis en dispersant AB et VGCF-H® dans la suspension de SR+CMC dans l'eau.

**Tableau 2**

| Ex. | VGCF-H® (%) | Liant | (%) | Matière active (%) |
|---|---|---|---|---|
| a | 7,59 | SR | 47,50 | 15,18 |
| | | CMC | 37,32 | |
| b | 7,59 | SR | 47,4992 | 15,18 |
| | | CMC | 37,3208 | |
| c | 7,59 | SR | 47,4992 | 15,18 |
| | | CMC | 37,3208 | |

### Préparation de l'anode comparative

On a déposé la composition destinée à former le film de matériau d'anode sur un collecteur de courant par la technique Doctor Blade, et on a soumis à un traitement thermique à 150°C pendant 12 heures sous vide pour éliminer le solvant. Le collecteur de courant est le cuivre tel qu'indiqué dans le Tableau 1.

Après traitement thermique, on a déposé la composition destinée à former le film protecteur à la surface du film de matériau d'anode, en utilisant la technique Doctor Blade. Ensuite, on a soumis à un traitement thermique à 120°C pendant 12 heures sous vide pour éliminer l'eau.

Enfin, on a compressé l'élément multicouche ainsi obtenu pour supprimer la rugosité et obtenir un matériau ayant une densité de 1,3 g/cm³.

### Exemple 2 : Préparation d'anode (liant SR+CMC)

On a préparé trois anodes selon le mode opératoire ci-dessous.

### Composition destinée à former le film de matériau d'anode

On a préparé une composition destinée à former le film de matériau d'anode. Les constituants de l'anode sont donnés dans le Tableau 3 ci-dessous. La composition destinée à former le film de matériau d'anode contient les constituants du matériau d'anode tels qu'illustrés dans le Tableau 1 et de l'eau. Dans la composition destinée à former le film de matériau d'anode, l'eau représente environ 17.67 g. Les quantités en poids sec de SR et CMC sont d'environ 3,47 g et 2,78 g, respectivement.

Selon un mode de réalisation de l'invention, il est possible d'ajuster la quantité d'eau dans la composition destinée à former le film protecteur. Par exemple, un ajustement à la hausse de la quantité d'eau facilitera l'application du film.

**Tableau 3**

| Ex. | Collecteur | MA* | % | VGCF-H® (%) | Liant | (%) | MA* (%) |
|---|---|---|---|---|---|---|---|
| d | Cuivre | SiOC | 44,859 | 3,738 | SR | 3.662 | 89,718 |
| | | OMAC | 44,859 | | CMC | 2,879 | |
| e | Aluminium PT402 | SiOC | 44,859 | 3,738 | SR | 3.662 | 89,718 |
| | | OMAC | 44,859 | | CMC | 2,879 | |
| f | Aluminium PT402 et carbon | SiOC | 44,859 | 3,738 | SR | 3.662 | 89,718 |
| | | OMAC | 44,859 | | CMC | 2,879 | |

| | | | | | | | |
|---|---|---|---|---|---|---|---|
| * Matière active | | | | | | | |

La composition destinée à former le film de matériau d'anode a été préparée en dispersant SR+CMC dans l'eau, puis en ajoutant la matière active et l'agent de conduction électronique.

### Composition destinée à former le film protecteur

On a préparé une composition destinée à former le film protecteur. Les constituants du film protecteur sont donnés dans le Tableau 4 ci-dessous.

**Tableau 4**

| Ex. | AB | VGCF-H® (%) | Liant | (%) |
|---|---|---|---|---|
| d | 5,039 | 5,039 | PVDF Kureha 10% | 89,926 |
| e | 5,037 | 5,037 | PVDF Kureha 10% | 89,926 |
| f | 5,037 | 5,037 | PVDF Kureha 10% | 89,926 |

La composition destinée à former le film protecteur a été préparée en ajoutant PVDF dans le solvant puis en dispersant AB et VGCF-H® dans la solution de PVDF.

Selon un exemple comparatif, on a déposé la composition destinée à former le matériau d'anode sur un collecteur de courant par la technique Doctor Blade, et on a soumis à un traitement thermique à 150°C pendant 12 heures sous vide pour éliminer le solvant. Le collecteur de courant est le cuivre tel qu'indiqué dans le Tableau 1.

Après traitement thermique, on a déposé à la surface du film de matériau d'anode obtenu après traitement thermique, la composition destinée à former le film protecteur, en utilisant la technique Doctor Blade. Ensuite, on a soumis à un traitement thermique à 120°C pendant 12 heures sous vide pour éliminer l'eau.

Enfin, on a compressé l'élément multicouche ainsi obtenu pour supprimer la rugosité et obtenir un matériau ayant une densité de 1,3 g/cm³.

### Exemple 3 : Caractérisation des anodes

Les anodes d, e ont été utilisées comme électrode de travail dans une cellule électrochimique dans laquelle :
- L'électrode de référence comprend un électrolyte de lithium métal
- L'électrolyte est LiPF₆ (1 mole) dans EC-DEC (3/7 volume/volume) et VC (2% wt).
   EC-DEC : Ethylene Carbonate-Diethyl carbonate.
   VC : Vinyl Carbonate

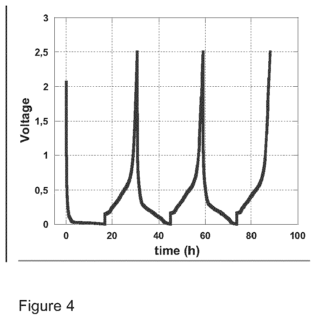

A titre comparatif, on a testé un échantillon ne comprenant pas de film protecteur (Figure 4).

Chaque cellule électrochimique a été soumise à une succession de cycles charges/décharge avec un régime C/24 (décharge en 24 heures) en mode galvanostatique entre 10 mV et 2,5 V à 25°C.

Pour chacune des cellules, on a déterminé :
- La capacité réversible au 1^{er} cycle, en mAh/g
- L'efficacité coulombique lors du 1^{er} cycle (C. Effi. 1) et lors du deuxième cycle (C. Effi. 2).

Les valeurs obtenues sont rassemblées dans Tableau 5 ci-dessous.

**Tableau 5**

| Batterie | Anode | Capacité réversible (mA/hg) | Efficacité coulombique 1 (%) | Efficacité coulombique 2 (%) |
|---|---|---|---|---|
| 1200B | d | 892 | 85 | 97 |
| 1200D | d (sans film protecteur) | 536 | 83 | 97 |
| 1202D | e | 1973 | 83 | 98 |
| 1202E | f | 1236 | 82 | 73 |

La comparaison des cellules 1200B et 1200D montre que la présence du film protecteur augmente de façon significative la capacité réversible, ce qui est un indice d'une diminution de l'expansion volumique lors de l'insertion d'ions lithium dans le matériau d'anode, sans diminuer l'efficacité coulombique 1 et l'efficacité coulombique 2.

La comparaison des cellules 1200B, 1202D et 1202E montre que l'utilisation d'un collecteur d'aluminium ou d'aluminium + carbone comme collecteur de courant augmente de manière substantielle la capacité réversible par rapport à l'utilisation d'un collecteur de courant en cuivre, sans agir notablement sur l'efficacité coulombique 1 et l'efficacité coulombique 2.

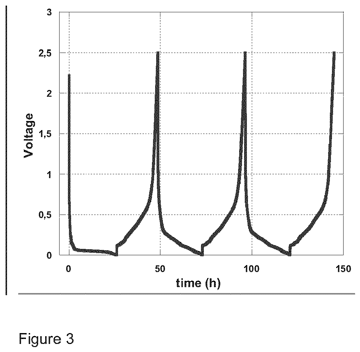

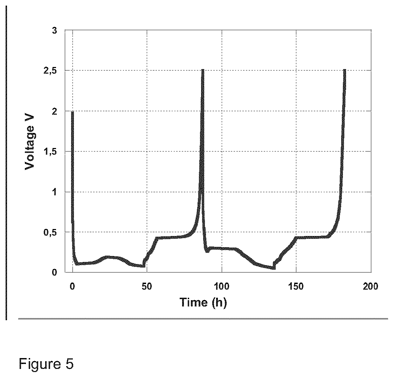

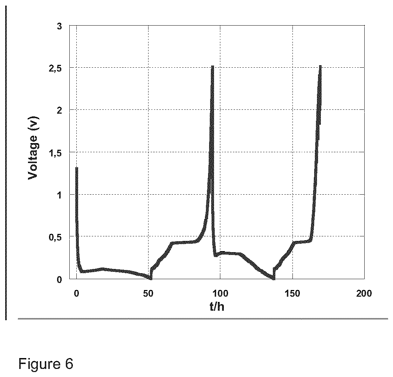

Les Figures 3, 4, 5 et 6 représentent la courbe charge/décharge des trois premiers cycles, respectivement pour les cellules 1200B, 1200D, 1202D et 1202E.

Les revendications ne doivent pas être limitées dans leur portée par les réalisations préférentielles illustrées dans les exemples, mais doivent recevoir l'interprétation la plus large qui soit conforme à la description dans son ensemble.

## Revendications

1. Anode comprenant un collecteur de courant (1) et un film de matériau d'anode (7),
**caractérisée en ce qu'**elle comprend en outre un premier film protecteur (6) et un deuxième film protecteur (3), le premier film protecteur (6) étant déposé sur le collecteur de courant (1), le film de matériau d'anode (7) étant déposé sur le premier film protecteur (6), et le deuxième film protecteur (3) étant déposé sur le film de matériau d'anode (7); et le matériau d'anode est un mélange comprenant une matière active (2), au moins un agent de conduction électronique (5A), et un liant (4A); dans lequel la matière active (2) est un alliage de silicium et de lithium ou un alliage d'oxyde de silicium et de lithium; et dans lequel le film protecteur (3, 6) comprend un matériau protecteur comprenant au moins un agent de conduction électronique (5B) et un liant (4B).

2. Anode selon la revendication 1, **caractérisée en ce que** le matériau d'anode (7) comprend en outre un graphite naturel ou synthétique.

3. Anode selon la revendication 1, **caractérisée en ce que** l'agent de conduction électronique dans le matériau d'anode (5A) et l'agent de conduction électronique dans le matériau protecteur (5B) sont indépendamment constitués d'au moins un carbone conducteur électronique, de préférence le carbone conducteur électronique est choisi parmi : les noirs de carbone, les noirs d'acétylène, les fibres de carbone telles que celles dites VGCF (« vapor grown carbon fiber », commercialisées par la compagnie Showa-Denko), les nanotubes de carbones et les graphènes.

4. Anode selon la revendication 1, **caractérisée en ce que** le liant dans le matériau d'anode (4A) et le liant dans le matériau protecteur (4B) sont indépendamment un polymère, de préférence le liant dans le matériau d'anode et le liant dans le matériau protecteur sont indépendamment choisis parmi : un polyfluorure de vinylidène (PVDF), un copolymère de fluorure de vinylidène et d'hexafluoropropène (PVFD-HFP), un polyimide, un caoutchouc naturel ou synthétique, une carboxyméthyle cellulose (CMC), un alginate sous forme d'acide ou sous forme d'un sel, et un mélange de ceux-ci.

5. Anode selon la revendication 1, **caractérisée en ce que** le matériau d'anode (7) se présente sous forme de particules dans le liant (4A), les particules étant des particules de la matière active et des particules de l'agent de conduction électronique (5A); et/ou dans laquelle le matériau d'anode (7) comprend en poids : 80-95% de la matière active (2), 1-10% de l'agent de conduction électronique (5A), et 2-20% du liant (4A).

6. Anode selon la revendication 1, **caractérisée en ce que** le film protecteur (3) se présente sous forme de particules dans le liant (4B), les particules étant des particules de l'agent de conduction électronique (5B); et/ou dans laquelle le matériau protecteur comprend en poids : 1-20% de l'agent de conduction électronique (5B) et 80-99% du liant (4B).

7. Anode selon l'une quelconque des revendications 1 à 6, **caractérisée en ce que** le collecteur de courant (1) est une feuille comprenant un métal, de préférence l'aluminium ou le cuivre; ou dans laquelle le collecteur de courant (1) est une feuille comprenant un métal et le carbone, de préférence l'aluminium et le carbone.

8. Anode selon la revendication 7, **caractérisée en ce que** la feuille métallique (1) comprend de l'aluminium.

9. Procédé d'élaboration d'une anode comprenant les étapes suivantes :
a) préparation d'une composition destinée à former un film de matériau d'anode (7), en mélangeant une matière active ou un précurseur de matière active, un premier liant et un premier agent de conduction électronique, dans un premier solvant, dans lequel la matière active (2) est un alliage de silicium et de lithium ou un alliage d'oxyde de silicium et de lithium;
b) préparation d'une composition destinée à former un premier et deuxième films protecteurs (6, 3), optionnellement deux compositions différentes, en mélangeant un deuxième agent de conduction électronique avec un deuxième liant, dans un deuxième solvant;
c) dépôt de la composition destinée à former lesdits films protecteurs, optionnellement une première des deux compositions, à la surface de la feuille métallique (1) formant le premier film protecteur (6), et élimination du deuxième solvant;
d) dépôt de la composition destinée à former le film de matériau d'anode (7) sur le premier film protecteur (6), et élimination du premier solvant; et
e) dépôt de la composition destinée à former lesdits films protecteurs, optionnellement une deuxième des deux compositions, à la surface du film de matériau d'anode (7) formant le deuxième film protecteur (3), et élimination du deuxième solvant.

10. Procédé selon la revendication 9, **caractérisé en ce que** :
l'ordre dans lequel les étapes a) et b) sont effectuées est indifférent; et/ou
l'élimination du premier solvant et/ou du deuxième solvant est effectuée par traitement thermique, de préférence sous vide; et/ou
comprenant en outre une étape (e) de compression de l'ensemble obtenu.

11. Procédé selon la revendication 9, **caractérisé en ce que** :
la composition destinée à former un film de matériau d'anode (7) comprend 5 à 20 parties en poids du premier solvant, et 80 à 95 parties en poids d'un mélange constitué par : 80-95% en poids de précurseur de matière active, 2-20% en poids du premier liant, et 1-10% en poids de carbone conducteur électronique; et/ou
la composition destinée à former un film protecteur (3, 6) comprend 5 à 20 parties en poids du deuxième solvant, et 80 à 95 parties en poids d'un mélange constitué par : 1-20% en poids de carbone conducteur électronique, et 80-99% en poids du deuxième liant.

12. Batterie comprenant une anode telle que décrite selon l'une quelconque des revendications 1 à 8, de préférence la batterie est une batterie au lithium.

13. Utilisation de l'anode telle que décrite selon l'une quelconque des revendications 1 à 8, dans la fabrication d'une batterie, de préférence une batterie au lithium.

14. Procédé de fabrication d'une batterie comprenant le procédé tel que décrit selon l'une quelconques des revendications 9 à 11, de préférence la batterie est une batterie au lithium.

## Patentansprüche

1. Anode, umfassend einen Stromkollektor (1) und einen Film eines Materials einer Anode (7), **dadurch gekennzeichnet, dass** sie ferner einen ersten Schutzfilm (6) und einen zweiten Schutzfilm (3) umfasst, wobei der erste Schutzfilm (6) auf dem Stromkollektor (1) abgeschieden ist, der Film des Materials der Anode (7) auf dem ersten Schutzfilm (6) abgeschieden ist und der zweite Schutzfilm (3) auf dem Film des Materials der Anode (7) abgeschieden ist; und das Anodenmaterial eine Mischung ist, die ein aktives Material (2), mindestens ein elektronisch leitendes Mittel (5A) und ein Bindemittel (4A) umfasst; wobei das aktive Material (2) eine Legierung von Silicium und Lithium oder eine Legierung eines Oxids von Silicium und Lithium ist; und wobei der Schutzfilm (3, 6) ein Schutzmaterial umfasst, das mindestens ein elektronisch leitendes Mittel (5B) und ein Bindemittel (4B) umfasst.

2. Anode nach Anspruch 1, **dadurch gekennzeichnet, dass** das Material der Anode (7) ferner natürlichen oder synthetischen Graphit umfasst.

3. Anode nach Anspruch 1, **dadurch gekennzeichnet, dass** das elektronisch leitende Mittel (5A) in dem Anodenmaterial und das elektronisch leitende Mittel (5B) in dem Schutzmaterial unabhängig aus mindestens einem elektronisch leitenden Kohlenstoff bestehen, vorzugsweise wobei der elektronisch leitende Kohlenstoff ausgewählt ist aus: Rußen, Acetylenrußen, Kohlenstofffasern wie solche, die VGCF ("vapor grown carbon fiber" bzw. " in Dampf(phase) gewachsene Kohlenstofffasern", vertrieben von der Firma Showa-Denko) genannt werden, Kohlenstoff-Nanoröhrchen und Graphenen.

4. Anode nach Anspruch 1, **dadurch gekennzeichnet, dass** das Bindemittel (4A) in dem Anodenmaterial und das Bindemittel (4B) in dem Schutzmaterial unabhängig ein Polymer sind, vorzugsweise wobei das Bindemittel in dem Anodenmaterial und das Bindemittel in dem Schutzmaterial unabhängig ausgewählt sind aus: Polyvinylidenfluorid (PVDF), einem Copolymer von Vinylidenfluorid und Hexafluorpropen (PVFD-HFP), einem Polyimid, einem natürlichen oder synthetischen Kautschuk, einer Carboxymethylcellulose (CMC), einem Alginat in Form einer Säure oder in Form eines Salzes, und einer Mischung davon.

5. Anode nach Anspruch 1, **dadurch gekennzeichnet, dass** das Material der Anode (7) in Form von Partikeln in dem Bindemittel (4A) vorliegt, wobei die Partikel Partikel des aktiven Materials und Partikel des elektronisch leitenden Mittels (5A) sind; und/oder wobei das Material der Anode (7) nach Gewicht: 80 bis 95 % des aktiven Materials (2), 1 bis 10 Gewichts-% des elektronisch leitenden Mittels (5A) und 2 bis 20 % des Bindemittels (4A), umfasst.

6. Anode nach Anspruch 1, **dadurch gekennzeichnet, dass** der Schutzfilm (3) in Form von Partikeln in dem Bindemittel (4B) vorliegt, wobei die Partikel Partikel des elektronisch leitenden Mittels (5B) sind; und/oder wobei das Schutzmaterial nach Gewicht: 1 bis 20 % des elektronisch leitenden Mittels (5B) und 80 bis 99 % des Bindemittels (4B), umfasst.

7. Anode nach irgendeinem der Ansprüche 1 bis 6, **dadurch gekennzeichnet, dass** der Stromkollektor (1) eine Folie ist, die ein Metall, vorzugsweise Aluminium oder Kupfer, umfasst; oder wobei der Stromkollektor (1) eine Folie ist, die ein Metall und Kohlenstoff, vorzugsweise Aluminium und Kohlenstoff, umfasst.

8. Anode nach Anspruch 7, **dadurch gekennzeichnet, dass** die Metallfolie (1) Aluminium umfasst.

9. Verfahren zur Herstellung einer Anode, das folgende Schritte umfasst:
a) Herstellung einer Zusammensetzung bestimmt zur Bildung eines Films eines Materials einer Anode (7), durch Mischen eines aktiven Materials oder einer Vorstufe des aktiven Materials, eines ersten Bindemittels und eines ersten elektronisch leitenden Mittels, in einem ersten Lösungsmittel, wobei das aktive Material (2) eine Legierung von Silicium und Lithium oder eine Legierung eines Oxids von Silicium und Lithium ist;
b) Herstellung einer Zusammensetzung bestimmt zur Bildung eines ersten und zweiten Schutzfilms (6, 3), gegebenenfalls von zwei verschiedenen Zusammensetzungen, durch Mischen eines zweiten elektronisch leitenden Mittels mit einem zweiten Bindemittel in einem zweiten Lösungsmittel;
c) Abscheiden der Zusammensetzung bestimmt zur Bildung der Schutzfilme, gegebenenfalls einer ersten von zwei Zusammensetzungen, auf der Oberfläche der Metallfolie (1), zur Bildung des ersten Schutzfilms (6), und Entfernen des zweiten Lösungsmittels;
d) Abscheiden der Zusammensetzung bestimmt zur Bildung des Films des Materials der Anode (7) auf dem ersten Schutzfilm (6) und Entfernen des ersten Lösungsmittels; und
e) Abscheiden der Zusammensetzung bestimmt zur Bildung der Schutzfilme, gegebenenfalls einer zweiten von zwei Zusammensetzungen, auf der Oberfläche des Films des Materials der Anode (7), zur Bildung des zweiten Schutzfilms (3), und Entfernen des zweiten Lösungsmittels.

10. Verfahren nach Anspruch 9, **dadurch gekennzeichnet, dass**: die Reihenfolge, in der die Schritte a) und b) ausgeführt werden, irrelevant ist; und/oder die Entfernung des ersten Lösungsmittels und/oder des zweiten Lösungsmittels durch Wärmebehandlung, vorzugsweise unter Vakuum, durchgeführt wird; und/oder ferner umfassend einen Schritt (e) des Komprimierens der erhaltenen Anordnung.

11. Verfahren nach Anspruch 9, **dadurch gekennzeichnet, dass**: die Zusammensetzung bestimmt zur Bildung eines Films des Materials der Anode (7) 5 bis 20 Gewichtsteile des ersten Lösungsmittels und 80 bis 95 Gewichtsteile einer Mischung bestehend aus: 80-95% Gewichts-% einer Vorstufe des aktiven Materials, 2 bis 20 Gewichts-% des ersten Bindemittels und 1 bis 10 Gewichts-% elektronisch leitendem Kohlenstoff, umfasst; und/oder die Zusammensetzung bestimmt zur Bildung eines Schutzfilms (3, 6) 5 bis 20 Gewichtsteile des zweiten Lösungsmittels und 80 bis 95 Gewichtsteile einer Mischung bestehend aus: 1-20 Gewichts-% elektronisch leitendem Kohlenstoff und 80-99 Gewichts-% des zweiten Bindemittels, umfasst.

12. Batterie, umfassend eine Anode, wie gemäß irgendeinem der Ansprüche 1 bis 8 beschrieben, vorzugsweise wobei die Batterie eine Lithiumbatterie ist.

13. Verwendung der Anode, wie gemäß irgendeinem der Ansprüche 1 bis 8 beschrieben, bei der Herstellung einer Batterie, vorzugsweise einer Lithiumbatterie.

14. Verfahren zur Herstellung einer Batterie, umfassend das Verfahren wie gemäß irgendeinem der Ansprüche 9 bis 11 beschrieben, vorzugsweise wobei die Batterie eine Lithiumbatterie ist.

## Claims

1. An anode comprising a current collector (1) and a film of a material of an anode (7), **characterized in that** it comprises further a first protective film (6) and a second protective film (3), wherein the first protective film (6) is deposited on the current collector (1), the film of the material of the anode (7) is deposited on the first protective film (6), and the second protective film (3) is deposited on the film of the material of the anode (7); and the anode material is a mixture comprising an active material (2), at least one electronic conduction agent (5A) and a binder (4A); wherein the active material (2) is an alloy of silicon and lithium or an alloy of oxide of silicon and lithium; and wherein the protective film (3, 6) comprises a protective material comprising at least one electronic conduction agent (5B) and a binder (4B).

2. The anode according to claim 1, **characterized in that** the material of the anode (7) further comprises natural or synthetic graphite.

3. The anode according to claim 1, **characterized in that** the electronic conduction agent (5A) in the anode material and the electron conduction agent (5B) in the protective material independently consist of at least one electronically conductive carbon, preferably the electronically conductive carbon is selected from: carbon blacks, acetylene blacks, carbon fibers such as those called VGCF ("vapor grown carbon fiber", marketed by the company Showa-Denko), carbon nanotubes, and graphenes.

4. The anode according to claim 1, **characterized in that** the binder (4A) in the anode material and the binder (4B) in the protective material are independently a polymer, preferably the binder in the anode material and the binder in the protective material are independently selected from: a polyvinylidene fluoride (PVDF), a copolymer of vinylidene fluoride and hexafluoropropene (PVFD-HFP), a polyimide, a natural or synthetic rubber, a carboxymethyl cellulose (CMC), an alginate in the form of an acid or in the form of a salt, and a mixture thereof.

5. The anode according to claim 1, **characterized in that** the material of the anode (7) is present in the form of particles in the binder (4A), the particles being particles of the active material and particles of the electronic conduction agent (5A); and/or wherein the material of the anode (7) comprises by weight: 80-95% of the active material (2), 1-10% of the electronic conduction agent (5A), and 2-20% of the binder (4A).

6. The anode according to claim 1, **characterized in that** the protective film (3) is present in the form of particles in the binder (4B), the particles being particles of the electronic conduction agent (5B); and/or wherein the protective material comprises by weight: 1-20% of the electronic conduction agent (5B) and 80-99% of the binder (4B).

7. The anode according to any one of claims 1 to 6, **characterized in that** the current collector (1) is a foil comprising a metal, preferably aluminum or copper; or wherein the current collector (1) is a foil comprising a metal and carbon, preferably aluminum and carbon.

8. The anode according to claim 7, **characterized in that** the metal foil (1) comprises aluminum.

9. A process for producing an anode comprising the following steps:
a) preparation of a composition intended to form a film of a material of anode (7), by mixing an active material or a precursor of active material, a first binder and a first electronic conduction agent, in a first solvent, wherein the active material (2) is an alloy of silicon and lithium or an alloy of oxide of silicon and lithium;
b) preparation of a composition intended to form first and second protective films (6, 3), optionally of two different compositions, by mixing a second electronic conduction agent with a second binder, in a second solvent;
c) depositing the composition intended to form the protective films, optionally a first of the two compositions, on a surface of the metal foil (1), to form the first protective film (6), and removing the second solvent;
d) depositing the composition intended to form the film of the material of the anode (7) on the first protective film (6), and removing the first solvent; and
e) depositing the composition intended to form the protective films, optionally a second of the two compositions, on the surface of the film of the material of the anode (7), to form the second protective film (3), and removing the second solvent.

10. The process according to claim 9, **characterized in that**: the order in which steps a) and b) are performed is irrelevant; and/or the removal of the first solvent and/or the second solvent is carried out by heat treatment, preferably under vacuum; and/or further comprising a step (e) of compressing the assembly obtained.

11. The process according to claim 9, , **characterized in that**: the composition intended to form a film of the material of the anode (7) comprises 5 to 20 parts by weight of the first solvent, and 80 to 95 parts by weight of a mixture consisting of: 80-95% by weight of precursor of the active material, 2-20% by weight of the first binder, and 1-10% by weight of electronically conductive carbon; and/or the composition intended to form a protective film (3, 6) comprises 5 to 20 parts by weight of the second solvent, and 80 to 95 parts by weight of a mixture consisting of: 1-20 % by weight of electronically conductive carbon, and 80-99% by weight of the second binder.

12. A battery comprising an anode as described according to any one of claims 1 to 8, preferably the battery is a lithium battery.

13. Use of the anode as described according to any one of claims 1 to 8 in the manufacture of a battery, preferably a lithium battery.

14. A process of manufacturing a battery comprising the process as described according to any one of claims 9 to 11, preferably the battery is a lithium battery.
